(19) **Europäisches Patentamt**
**European Patent Office**
**Office européen des brevets**

(11) **EP 1 326 084 B1**

(12) **EUROPÄISCHE PATENTSCHRIFT**

(45) Veröffentlichungstag und Bekanntmachung des Hinweises auf die Patenterteilung:
**22.04.2009 Patentblatt 2009/17**

(51) Int Cl.:
***G01R 31/36*** *(2006.01)*

(21) Anmeldenummer: **02090423.1**

(22) Anmeldetag: **20.12.2002**

(54) **Verfahren zur Bewertung des Zustandes von Batterien**

Method for detecting the condition of batteries

Méthode pour la détection de la condition des batteries

(84) Benannte Vertragsstaaten:
**AT BE BG CH CY CZ DE DK EE ES FI FR GB GR IE IT LI LU MC NL PT SE SI SK TR**

(30) Priorität: **08.01.2002 DE 10201136**

(43) Veröffentlichungstag der Anmeldung:
**09.07.2003 Patentblatt 2003/28**

(73) Patentinhaber: **SIEMENS AKTIENGESELLSCHAFT 80333 München (DE)**

(72) Erfinder:
• **Köster, Kay**
 **15370 Fredersdorf (DE)**
• **Walter, Harald**
 **12557 Berlin (DE)**

(56) Entgegenhaltungen:
**EP-A- 0 711 016**          **DE-A- 3 150 758**
**US-A- 5 394 089**

EP 1 326 084 B1

**Beschreibung**

Die Erfindung betrifft ein Verfahren zur Bewertung des Zustandes von Batterien in batteriegestützten, photovoltaischen Stromversorgungsanlagen mit mindestens zwei parallelen Bitteriezweigen, die je nach Ladezustand abwechselnd eine Last mit Energie versorgen oder von einem Generator nachgeladen werden, wobei von einer erstmalig an der Stromversorgungsanlage in Betrieb genommenen, aufgeladenen Batterie nach Freischaltung von der Stromversorgungsanlage mittels einer Steuereinheit selbsttätig in einem stufenweisen Entladezyklus an einem Entladewiderstand eine Entladekennlinie der Ruhespannung aufgenommen wird, dieser stufenweise Entladezyklus zu festzulegenden Zeitpunkten zur Aufnahme einer aktuellen Entladekennlinie der Ruhespannung wiederholt wird, mindestens die zuletzt aufgenommene Entladekennlinie der Ruhespannung gespeichert wird, und aus einer zuvor festgelegten Reservezeit und der bei der ersten Messung ermittelten Entladeschlussspannung aus der aktuellen Entladekennlinie der Ruhespannung eine Alarm-Ruhe-Spannung ermittelt wird, die ein Maß für eine jeweils noch verbleibende Restenergie der Batterie darstellt und bei deren Erreichen beim Betrieb an der Last eine Alarmierung des Betreibers der Stromversorgungsanlage erfolgt.

Derartige photovoltaische Stromversorgungsanlagen mit Batteriepuffer dienen zur Speisung beliebiger elektrotechnischer Einrichtungen wie Steuerungen, Kommunikationseinrichtungen, Lampen, Motoren u.a.m.

Ein gattungsgemäßes Verfahren zur Bewertung des Zustandes von Batterien ist aus der US 4 731 601 bekannt.

Ein Hauptproblem in batteriegestützten Stromversorgungsanlagen besteht in der Bewertung des Ladezustandes, der Alterung und der Lebenserwartung der Energiespeicher, unabhängig von der Nutzung eines Energiespeichers als Not-, Stütz- oder zyklisch betriebene Arbeitsbatterie. Die Notwendigkeit einer gesicherten Aussage über den Speicherzustand einer Batterie muss insbesondere dann als sehr hoch angesehen werden, wenn die batteriegestützten Stromversorgungen zur Speisung von Anlagen mit erhöhten Sicherheits- oder Verfügbarkeitsanforderungen dienen. Von besonderer Wichtigkeit ist die Bestimmung des Batteriezustandes bei abgesetzten, automatisch betriebenen Inselanlagen, die in der Regel über längere Zeiträume (Wochen, Monate) unbeaufsichtigt arbeiten und keine Wartung erfahren, da die Aufwendungen zum Tausch der Batterien, z.B. bei Seezeichen, in schwer zugänglichen oder schwach besiedelten Gebieten, teilweise sehr hoch sein können.

Bekannt ist die ständige Überwachung von Batterien und die Einhaltung der in den Betriebsvorschriften für derartige Anlagen festgeschriebenen Fristen für prophylaktische Austauschprozeduren. Unabhängig vom realen Alterungszustand der Batterien werden die Batterien der Anlage entnommen und gegen neuwertige ausgetauscht. Im günstigsten Fall erfolgt eine Aufarbeitung der gealterten Batterien oder ein wertstoffgerechtes Recycling. Dieses Verfahren erfordert einen hohen Wartungsaufwand. Außerdem verbietet der zunehmend sparsame Umgang mit Ressourcen beliebig oft, rein prophylaktisch durchzuführende Austauscharbeiten von Batterien.

Aus der DE 196 05 481 C1 ist ein Batteriemessmodul für eine USV-Batterie bekannt. Mittels des Batteriemessmoduls werden die Blockspannungen der einzelnen Blockbatterien der USV-Batterie ermittelt. Auf diese Weise kann eine defekte Blockbatterie lokalisiert werden. Der Ladezustand der USV-Batterie in Abhängigkeit von anderen Parametern ist nicht feststellbar.

Für die Ersatzversorgung einer konstanten Last ist gemäß der DE 42 38 316 A1 vorgesehen, die Kapazität der Batterie soweit herabzusetzen, dass der Funktionszeitraum der Batterie genau einer vorgegebenen Zeitspanne entspricht. Dadurch ergibt sich eine vorteilhafte Entladecharakteristik.

Zur Feststellung des Funktionszustandes eines Akkumulators wird dieser gemäß der DE 38 21 808 A1 über eine definierte Zeitspanne mit einem definierten Strom belastet, wobei die Akkuspannung mit den Spannungswerten einer Sollkennlinie verglichen wird. Sinkt die Akkuspannung unterhalb des Sollwertes, gilt der Akkumulator als funktionsuntüchtig.

Aus der DE 39 10 868 A1 ist ein Verfahren zur Ermittlung des Ladezustandes einer Bleibatterie bekannt. Dabei werden Bezugsspannungen ermittelt, von denen bei Lastaufschaltung eine Differenzspannung abgezogen wird. Die Bezugsspannungen werden experimentell ermittelt und zu einer Bezugslinie extrapoliert. Das Verfahren ermöglicht einen Schutz vor Tiefentladung der Batterie bei unterschiedlicher Lastaufschaltung.

Weit verbreitet ist ein Verfahren zum Berechnen der Kapazitätsbilanz zwischen aufgenommenen und abgegebenen Amperestunden. Bei Kenntnis der Anfangskapazität, Ermittlung des Ruhestromverbrauches sowie Beurteilung der Ruhespannung zur Kapazität kann somit der Ladezustand der Batterie mit hinreichender Genauigkeit bewertet werden, insbesondere dann, wenn mit Korrekturfaktoren die Temperatureinflüsse kompensiert sind. Der Vorteil dieses Verfahrens liegt in der einfachen Auswertung unabhängig von den chemischen Prozessen innerhalb der Batterie. Durch die ständig anliegende Spannung in Höhe der Ladeschlussspannung ist in netzbetriebenen Stromversorgungsanlagen diese Berechnung immer genau, weil die Batterie im ausbalancierten Zustand immer voll geladen ist. Bei autonomen Anlagen im Inselbetrieb wird jedoch der große Nachteil dieses Verfahrens spürbar. Selbst durch kleinste Messfehler bei der Stromerfassung integriert sich über die Zeit eine derart hohe Abweichung von den Realwerten, dass die Energiebilanz stark fehlerbehaftet und für gezielte Zustandsanalysen unbrauchbar wird. Dieses Problem verschärft sich insbesondere in Stromversorgungen, die Lasten ereignisgesteuert versorgen, das heißt in Anlagen, bei denen über einen bestimmten Zeitraum nur geringe Energie für Überwachungszwecke, aber bei Auslösung eines Ereignisses größere Energiemengen zum Betreiben von Lasten bereitgestellt werden sollen. Zudem muss bei autonomen Anlagen immer davon ausgegangen werden, dass die Energiebilanz über längere Zeiträume nicht ausgeglichen ist. Dieses Problem ist bekannt, daher erfolgt in der Regel zu bestimmten Zeitpunkten eine Neukalibrierung des Messsystems und der Energiespeicher. Durch externe Energiezuführung wird der Speicher wieder in den Zustand der Vollladung gebracht. Mit der Überwachung des Messsystems und der Netzabhängigkeit zum gezielten Aufladen der Batterien sind jedoch hohe Aufwendungen verbunden.

Ein anderes bekanntes Verfahren bezieht sich auf die Messung der Spannung an den Batterieklemmen. Dabei wird die Erkenntnis genutzt, dass die Spannung an einer Batterie nach Abklingen der mit der Ladung und Entladung verbundenen chemischen Prozesse ein Maß für den Ladezustand darstellt. Dieses Verfahren setzt jedoch voraus, dass die Batterie aus der Anlage entnommen und über mehrere Stunden in den Ruhezustand versetzt wird, um hinreichend genaue Messungen zu erzielen.

Fuzzy-Algorithmen nutzen unter Verwendung von Lade- und Entladekennlinien der Batteriehersteller und Messung von Strom und Spannung an der Batterie Simulationsverfahren zur Berechnung des augenblicklichen Ladezustandes. Diese Verfahren sind relativ genau bei stark zyklischem Betrieb der Batterie, sind jedoch fehlerbehaftet bei Ladezuständen der Batterie über 80%, bei kleinen Lade- und Entladeströmen und bei großen Temperaturdifferenzen im Einsatzfall. Die erforderliche Kalibrierung der Anlage erfolgt wie bei Systemen mit einer Strommessung.

Der Erfindung liegt die Aufgabe zugrunde, ein Verfahren anzugeben, mit dem zur Reduzierung des Wartungsaufwandes nur bei erschöpften Energiespeichern ein gezielter Serviceeinsatz erfolgen soll. Das System soll entscheiden können, ob es sich um einen zeitweiligen Zustand der Anlage handelt, der mit unzureichendem Energiegewinn zusammenhängt oder das Ende des Lebenszyklus bedeutet. Da in verschiedenen Anlagen in der Regel unterschiedliche Kapazitäten und Spannungen auftreten, soll das Verfahren geeignet sein, die Bewertung der Batterien automatisiert und ohne Eingabe von gesetzten Werten als Ausgangsgrößen vorzunehmen. Außerdem soll das Verfahren geeignet sein, unabhängig vom Lastverhalten in der jeweiligen Anlage gesicherte Aussagen über die Verfügbarkeit des Energiespeichers zu treffen.

Erfindungsgemäß wird die Aufgabe gelöst durch die Merkmale des Anspruches 1. Zweckmäßige Ausgestaltungen sind Gegenstand der Unteransprüche.

Der Sinn des Verfahrens besteht insbesondere in der Bestimmung eines Zeitpunktes für den gezielten Tausch der Batterien. Dabei muss eine derartige Reserve für die gesicherte Stromversorgung gegeben sein, die es dem Betreiber ermöglicht, innerhalb einer Reservezeit die Anlage zu erreichen und zu warten.

Die Erfindung setzt eine autonome Stromversorgungsanlage in einer Anordnung von mindestens zwei oder mehr parallelen Batteriezweigen, die je nach Ladezustand abwechselnd die Last mit Energie versorgen oder von einem Generator nachgeladen werden, voraus, wobei zweckmäßig parallel zu jeder Batterie jeweils ein Spannungsmesser sowie je ein Schalter mit in Reihe geschaltetem Widerstand angeordnet sind. Jeder Batteriezweig verfügt über je einen Generator- und je einen Lastschalter.

Zu einem geeigneten Zeitpunkt wird eine neuwertige Batterie von der Last getrennt und vom Generator auf die Ladeschlussspannung aufgeladen. Nach Abtrennung der Batterie vom Generator und Ablauf einer Beruhigungszeit wird die Klemmspannung an der Batterie gemessen und gespeichert. Danach wird die Batterie in einem ersten Entladezyklus stufenweise entladen, indem der parallel zur Batterie liegende Schalter betätigt wird und durch den Widerstand der Batteriestrom fließt. Zu bestimmten Zeitpunkten wird die Entladung unterbrochen und nach Ablauf einer Wartezeit die Spannung gemessen. Danach wird weiter wie beschrieben entladen, bis die Entladeschlussspannung erreicht ist. Durch Speicherung der Spannungswerte über den Entladezeitraum lässt sich die Entladekennlinie der Ruhespannung nachbilden. Nach Abschluss dieser Messungen wird die Batterie wieder aufgeladen und in den Stromversorgungsverbund zurückgeschaltet.

Die beschriebene Entladeprozedur wird zu beliebigen, festzulegenden Zeitpunkten wiederholt, wobei eine Vereinfachung derart möglich ist, dass gezielt markante Punkte der Entladekennlinie angesteuert werden. Insbesondere beim Erreichen einer Spannung, die der Entladeschlussspannung nahe kommt, sollten zur Erfassung des genauen Verlaufs der Entladekennlinie mehrere Messpunkte aufgenommen werden. Die Messung erfolgt immer in einem gleichen Modus, das heißt mit gleichen Zeiten sowohl für die Entladeperioden als auch für die anschließenden Ruhezeiten.

Aus der Rückrechnung der zuvor festgelegten Vorwarn- und Reservezeit ergibt sich die Entladespannung, bei der ein kritischer Anlagenzustand erreicht ist. Gleichzeitig kann durch Berechnung der Fläche zwischen dem Zeitpunkt des Beginns der Reservezeit und dem Zeitpunkt des Erreichens der Entladeschlussspannung ein Maß für die der Stromversorgung maximal zur Verfügung stehenden Restenergie gefunden werden. Da sich in der Regel die Entladecharakteristik von Batterien im Bereich der tiefen Entladungen während deren Lebenszeit im Verhältnis zur Gesamt-Entladekennlinie kaum ändert, kann dieser Spannungswert für weitere Analysezwecke herangezogen werden.

Aus der Änderung der Verringerung der Entladezeit zwischen Batterieentladungen kann einmal der Fortschritt der Alterung ermittelt werden, zum anderen kann das Messsystem daraus auch das Zeitfenster zwischen zwei Batterieentladungen bestimmen. Diese Methode ist zur Vermeidung von unnötigen Stressbedingungen des Batterietests gegenüber der Vorgabe konstanter Zeitraster für Entladevorgänge vorzuziehen.

Auf diese Art und Weise wird die Historie der Lebenszeit der Batterie aufgezeichnet. Anhand der Veränderung der Spannungsdifferenz zwischen definierten Messpunkten und der Verringerung der Entladezeit sowie der Veränderung der Entladekennlinie, vorzugsweise im Bereich der Entladeschlussspannung, kann eine Aussage über die in der Batterie noch speicherbare Kapazität und die Alterung getätigt werden.

Eine Batterie gilt nach diesem Verfahren dann als erschöpft und für den Betreiber im konkreten Einsatzfall am Ende ihres Lebenszyklus, wenn die Entladung derart schnell erfolgt, dass nach Zuschalten der voll geladenen Batterie zum Betreiben einer Last die Spannung auf den kritischen Wert der Entladung (Alarm-Ruhe-Spannung) zusammenbricht, die die minimale Energiemenge für die Vorwarn- oder Reservezeit charakterisiert und bei der beispielsweise über Fernwirksignalisierung eine Wartung oder Instandhaltung veranlasst wird.

Zur Berechnung der benötigten minimalen Restenergie für die Aufrechterhaltung des Betriebes in der Reservezeit können mittels Strommessung typische Lastverläufe der Anlage ermittelt werden. Durch Vergleich mehrfach durchgeführter Messungen und Bildung des arithmetischen Mittelwertes relativiert sich der Integrationsfehler über der Zeit. Der Integrationsfehler kann weiterhin durch geeignete Wahl der Messzeit begrenzt werden. Da bei Start eines neuen Messzyklus alle Werte zurückgesetzt werden, treten keine Folgefehler auf. Typische Erfassungszeiten betragen etwa ein Tag oder eine Woche. Diese Messungen werden periodisch wiederholt. Somit reagiert die Stromversorgung auf Änderungen im Lastverhalten der Anlage und kann eine Korrekturberechnung des Restspeicherinhaltes für die vorab vom Betreiber definierte Reservezeit vornehmen.

Der Vorteil des Verfahrens besteht darin, dass durch eine einfache Spannungsmessung und eine Zeitsteuerung ohne hohe Genauigkeitsanforderungen der Zustand einer aus dem Stromversorgungsverbund freigeschalteten Batterie getestet und durch Vergleich mit im Messsystem gespeicherten Daten vorheriger Messungen eine Analyse über deren Alterung und Lebenserwartung getätigt werden kann. Integrationsfehler durch zeitabhängige Messverfahren oder Neukalibrierungen entfallen. Somit ist ein vollautomatischer Betrieb durchführbar. Da bei allen Betrachtungen relative Größen ermittelt werden, ist weder die Kenntnis der absoluten Kapazität noch des Typs der Batterie notwendig. Das Verhalten der Last ist ebenfalls nicht relevant, da der Entladetest immer an der gleichen Last, vorzugsweise mit konstantem Strom, stattfindet. Es genügt vielmehr, die Technologieart der Batterie (Blei-, NiCd-, Li-Ionen-Batterie, etc.) einzugeben. Anhand der anliegenden Batteriespannung legt das System die Lade- und Entladeschlussspannung sowie das Lade-/Entladeverfahren fest.

Weiterhin bestimmt der Betreiber der Anlage die für diesen Einsatzfall relevanten Zeiten für Vorwarnung und Reserve. Somit besteht die Möglichkeit der selektiven Nutzungsdauer der Energiespeicher in jeder Anlage. Im Prinzip ist die Festlegung einer Reservezeit für den Anwender ausreichend, um einen gezielten Wartungseinsatz einzuleiten. Die Vorwarnzeit dient einzig dem Zweck, dem Betreiber Möglichkeiten einer Servicestrategie einzuräumen.

Vorteile ergeben sich weiterhin aus der Bewertung von Schäden an Batterien. Sinkt bei einem Batteriezweig plötzlich die Spannung, schaltet die Steuerung zunächst auf einen anderen Batteriezweig zur Versorgung der Last um. Ein Vergleich mit den für den nicht als ordnungsgemäß arbeitend befundenen Batteriezweig hinterlegten Messdaten und einer evtl. durchzuführenden Nachladung gibt Aufschluss darüber, ob durch ein außerordentliches Ereignis an der Last eine sehr hohe Entladung, etwa durch einen zeitweiligen Kurzschluss, oder aber ein Zellenkurzschluss innerhalb der Batterie vorliegt. Da das System den Verlauf der letzten Entladekennlinie gespeichert hat, genügt eine Teilentladung zur Bewertung des Batteriezustandes. Liegt der Verlauf der Entladekennlinie der eingeleiteten Teilentladung im engen Toleranzfeld der letzten gemessenen, so hat ein zeitweiliger äußerer Kurzschluss vorgelegen. Weicht die Spannung beim Einschalten des Entladewiderstandes über die Toleranz der letzten Entladekennlinie hinaus (stark) ab, kann von einem Zellenkurzschluss ausgegangen werden.

Über die beschriebenen Tests hinaus können weitere Tests vorgenommen werden. So kann durch eine einmalige Messung der Ruhespannung auf den aktuellen Ladezustand der Batterie geschlossen werden. Durch einen Ruhespannungstest über einen definierten Zeitraum und an einer aus der Stromversorgungsanlage freigeschalteten Batterie mittels zweier Spannungsmessungen in einem Zeitintervall kann die Selbstentladung als ein Zeichen der Alterung festgestellt werden.

Wird die Last über einen bestimmten Zeitraum ohne Generator, das heißt nur an der Batterie eines Batteriezweiges betrieben, kann der von der Last benötigte Energiebedarf ermittelt werden. Aus diesem Verbrauchertest erfolgt eine Rückrechnung der Zeit bis zur Entladung der jeweiligen Batterie. Zusätzlich kann bei Änderungen des Lastverhaltens durch äußere Einflüsse (Kurzschlüsse, Schwerlast, Änderung des Betriebsregimes) die sich ergebende Verkürzung der Entladezeit berechnet werden.

Bei Stromversorgungsanlagen im Inselbetrieb ergeben sich anhand der Kenntnis der Batteriekapazitäten und Ladezustände in den einzelnen Zweigen des Energiespeichers unterschiedliche Strategien zur Umschaltung zwischen Ladung, Lastversorgung und Bereitschaftshaltung. Ziel der Steuerung ist die Erreichung bzw. Aufrechterhaltung des maximalen Energieinhaltes im Batteriespeicher. Es sind mindestens drei Grundvarianten von Umschaltstrategien sinnvoll, zwischen denen eine automatisch arbeitende Steuerung je nach Energieeintrag durch den Generator oder/und Energieverbrauch durch die Last eigenständig entscheiden kann.

Eine erste Grundvariante besteht darin, dass die Steuerung zwischen den Batteriezweigen zur Versorgung der Last im Zeitraster der vom Betreiber gewählten Reservezeit umschaltet, wobei der Generator jeweils die zuletzt mit der Last verschaltete Batterie nachlädt. Hierbei bleibt die Stromversorgungsanlage immer auf einem hohen Niveau der Speicherkapazität bei nur geringer Zyklisierung der Batterien.

Eine zweite Variante besteht darin, einen Batteriezweig mit der Last zu verbinden und diesen soweit zu entladen, bis die aus der letzten vom Messsystem gespeicherten Entladekennlinie ermittelte kritische Entladespannung erreicht ist, die als Kenngröße für die Größe der Reservekapazität zur Versorgung der Last dient. In diesem Fall wird jeder Batteriezweig einer Zyklisierung ausgesetzt, was durchaus lebensdauerfördernd wirkt. Die Batterien sollten jedoch nicht bis zur Entladeschlussspannung betrieben werden, da bei einem Fehler während der Umschaltung auf einen anderen Batteriezweig oder durch Schäden in anderen Batteriezweigen oder am Generator noch mindestens die Energiemenge bereitstehen muss, die bei typischem Lastverlauf den Betrieb innerhalb der Reservezeit durch Rückschaltung auf die zuletzt entladene Batterie aufrecht erhält. Der Generator lädt bei dieser Variante immer vorrangig die am meisten entladene Batterie auf.

Die dritte Möglichkeit besteht in der Steuerung eines reinen Standby-Betriebes. Hierzu speisen Generator und ein Batteriezweig ständig die Last. Die anderen Batteriezweige stehen geladen in Bereitschaft. Durch zyklisches Umschalten des Generators auf einen anderen Batteriezweig zur Versorgung der Last, wird außerdem der jeweilige Zweig zum Ausgleich der Selbstentladung nachgeladen. Da bei dieser Variante in der Regel die tägliche Energiebilanz ausgeglichen ist, kann ständig von einem fast vollständig geladenen Energiespeicher ausgegangen werden. Obwohl dieser Zustand am ehesten anzustreben ist, müssen die Nebenwirkungen von voll geladenen Batterien je nach chemischem Typ beachtet werden, da auch Lebensdauerverkürzungen eintreten können.

Da kein oben beschriebenes Verfahren geeignet ist, als solches die Batteriezweige optimal zu betreiben, kann das Steuerungssystem gegebenenfalls auf Grundlage der vom Messsystem ermittelten Entladekennlinien der einzelnen Batteriezweige, deren Ladezuständen sowie dem verfügbaren Energieangebot mit dem Ziel der Ausschöpfung der maximalen Lebensdauer der Energiespeicher zyklisch zwischen diesen Verfahren umschalten.

Bei autonomen Stromversorgungsanlagen mit photovoltaischem Generator, d.h. mit statistisch verteiltem Energiegewinn ergeben sich zusätzliche Lösungsschwerpunkte. Zusätzlich zu den Steueralgorithmen für Batterie und Last sowie Festlegung der Tests durch Batterieentladung einzelner Zweige des Energiespeichers stellt sich hier das Problem, dass nicht immer genügend Energie für einen dauerhaften Betrieb der Anlage durch den Photovoltaikgenerator bereitgestellt werden kann. Die Hauptaufgabe besteht darin, die Zeiträume zu definieren, in denen ein Batterietest vorgenommen werden kann, aber anderseits auch sichergestellt ist, dass die entladene Batterie im Sinne der Aufrechterhaltung der Gesamtfunktionalität der Stromversorgung möglichst schnell wieder aufgeladen werden kann.

Zu diesem Zweck wird durch Messung der Spannung am photovoltaischen Generator der tägliche Hell-/Dunkelzeitraum ermittelt und das sonnentägliche Mittel berechnet. Die tägliche Differenz der Hellzeit zwischen zwei Tagen wird vom Messsystem ebenfalls hinterlegt. Mit diesen Messpunkten wird im günstigsten Fall nach einem halben, spätestens nach einem dreiviertel Jahr der Sonnengang am jeweiligen Aufstellungsort der Anlage erkannt und als Grundlage für den Generatorbetrieb gespeichert. Die Stromversorgungsanlage arbeitet nach Erkennung des Sonnenganges in einem eigenen relativen Zeitrahmen, dessen Eckpunkte aus den Sonnenwendepunkten und der kleinsten bzw. größten Hellzeit innerhalb einer Periode bestehen. Die Hinterlegung von Kalendarien oder realen Zeiten ist für die Funktion der Stromversorgung spätestens nach Erkennung des Sonnenganges von untergeordneter Bedeutung und wird gegebenenfalls nur zu Vergleichszwecken für abzusetzende Statusmeldungen benötigt. Der Vorteil dieses relativen Zeitsystems nach dem astronomischen Gang der Sonne schließt alle Unregelmäßigkeiten kalendarischer oder realzeitlicher Festlegungen (Schaltjahr, Sommer-/Winterzeit) aus. Es entfällt ebenfalls die Installation eines Präzisionszeitgebers und eine Informationsübergabe von Zeitinformationen zur Zeitsynchronisation mit der Außenwelt. Zum jeweiligen Zeitpunkt der ermittelten Hälfte der Dunkelzeit zwischen zwei Tagen wird der interne Zeitgeber zurückgesetzt bzw. synchronisiert. Somit bleiben Fehler auf einen definierten Zeitraum begrenzt. Die Anforderungen an die Genauigkeit der Taktzeit sind gering; nur die Stabilität der Taktzeit sollte so gewählt sein, dass die Differenz der Sonnengangzeiten im Bereich der Sonnenwende größer als der Fehler des internen Zeitgebers bleibt.

Die Kenntnis des jährlichen Sonnenganges dient in erster Linie der Festlegung von Zeitfenstern für die Durchführung von Entladetests der Batteriezweige. Im Zeitraum der unteren Sonnenwende (Winteranfang) werden Testvorgänge ausgeschlossen. Vielmehr dient die Gewinnung aller verfügbaren Energie dem Zweck der Aufrechterhaltung der Funktion der Stromversorgung und der Sicherung eines möglichst hohen Ladezustandes der Batterien. Im Bereich der unteren Sonnenwende ist in der Regel die Energiebilanz über bestimmte Zeiträume negativ und die eintretenden Kapazitätsverluste im Energiespeicher müssen wegen der zu erwartenden niedrigen Temperaturen ausgeglichen werden. Ebenfalls kritisch ist der Bereich der oberen Sonnenwende (Sommeranfang), da in diesem Zeitraum mit hohen Temperaturen zu rechnen ist. Bei hohen Temperaturen reagieren die meisten elektrochemischen Energiewandler sehr sensibel auf Ladeströme, was oftmals zu Überladung führt und die Lebensdauer der Batterien wesentlich verkürzen kann. Aus diesem Grund wird als optimaler Punkt ein Bereich zwischen den Sonnenwendepunkten gewählt, um die Batterietests vorzunehmen.

Idealerweise wird anhand der zweiten Ableitung einer Kurve des jährlichen Sonnenganges die Wendestelle des Anstieges ermittelt. Im einfachsten Fall genügt aber der Bereich des Sonnenganges, bei dem die Differenz zwischen den Hellzeiten gleich ist. In der Regel ergeben sich die Zeiten im Bereich des Frühjahrs- und des Herbstbeginns zusätzlich einer Korrektur. Die Korrektur eines günstigen Entladezeitpunktes für Batterietests sollte vor diesen Wendestellen liegen, so dass die Aufladung der entladenen Batterie zum Zeitpunkt des Frühjahrs-, aber insbesondere des Herbstbeginns erfolgt. Insbesondere im absteigenden Bereich des Sonnenganges kann die Verringerung der Einstrahlung die Ladezeit unnötig verlängern und die Verfügbarkeit aufgeladener Energiespeicher schmälern.

Kann eine Information der Realzeit übertragen werden, vereinfacht sich die Prozedur der Festlegung von Testzeiträumen. Durch Synchronisation der tatsächlichen Zeit mit der internen, vom System nach dem astronomischen Sonnengang ermittelten Zeit, kann ebenfalls eine Freigabe oder Sperrung der Batterietests erteilt werden.

Die Funktionsabläufe einer im Inselbetrieb arbeitenden Stromversorgung mit photovoltaischem Generator sind in folgender Reihenfolge darstellbar:

- Inbetriebnahme der Stromversorgung vorzugsweise mit (mindestens einer) geladenen Batterie
- Versorgung der Last im konstanten Umschaltrhythmus zwischen den Batteriezweigen
- Beginn der Messungen des Energieverbrauchs durch die Last
- gleichzeitig Beginn der Messungen der Hell-/Dunkelzeit
- nach mindestens einem halben Jahr Erkennung des typischen Energiebedarfs der Last und des jährlichen Sonnenganges
- Einleitung eines ersten Batterietests durch Freischalten aus der Anlage im Bereich des aufwärts gehenden Sonnenganges (Frühjahr), Aufnahme einer ersten Entladekennlinie mit einer größeren Anzahl von Messpunkten
- Berechnung der kritischen Spannung an der Batterie zur Gewährleistung einer Restkapazität für die Aufrechterhaltung des Betriebes in einer vom Betreiber festgelegten Reservezeit
- Wiederaufladung der getesteten Batterie und Rückschaltung in den Verbund der Stromversorgung
- evtl. Einleitung weiterer Tests bei anderen Batterien
- Betrieb der Anlage im Zeitraum der oberen Sonnenwende vorzugsweise im Betrieb mit starker Zyklisierung
- im Zeitraum der Wendestelle des absteigenden Sonnenganges Einleitung von Batterietests mit nur wenigen markanten Messpunkten, Feststellung der Differenz zwischen der ersten und der soeben erfolgten Entladung
- Wiederaufladung der getesteten Batterie und Rückschaltung in den Verbund der Stromversorgung
- Betrieb der Anlage im Zeitraum der unteren Sonnenwende vorzugsweise im Standby-Modus, bzw. so, dass alle Batteriezweige möglichst vollgeladen sind

Auf diese Art und Weise der Betriebs- und Testführung kann ermittelt werden, wie die Batterie das Winterhalbjahr überstanden hat, bzw. wird überprüft, ob sie nach dem Sommer noch die Kapazität aufbringt, um den Winterbetrieb zu überstehen. Die Änderung der Differenz der Entladezeiten ermöglicht wie beschrieben eine Aussage über den Fortschritt des Alterungsprozesses.

Sämtliche Funktionsabläufe der Tests sowie die Ermittlung des Sonnengangs und die Aufzeichnung der gemessenen Daten werden durch einen Rechner gesteuert. Die entsprechende Software, die das erfindungsgemäße Verfahren repräsentiert, kann in einem Prozessor oder anderen geeigneten Speichermedien gespeichert sein.

Die Erfindung soll nachstehend anhand eines Ausführungsbeispiels näher erläutert werden. In den zugehörigen Zeichnungen zeigen

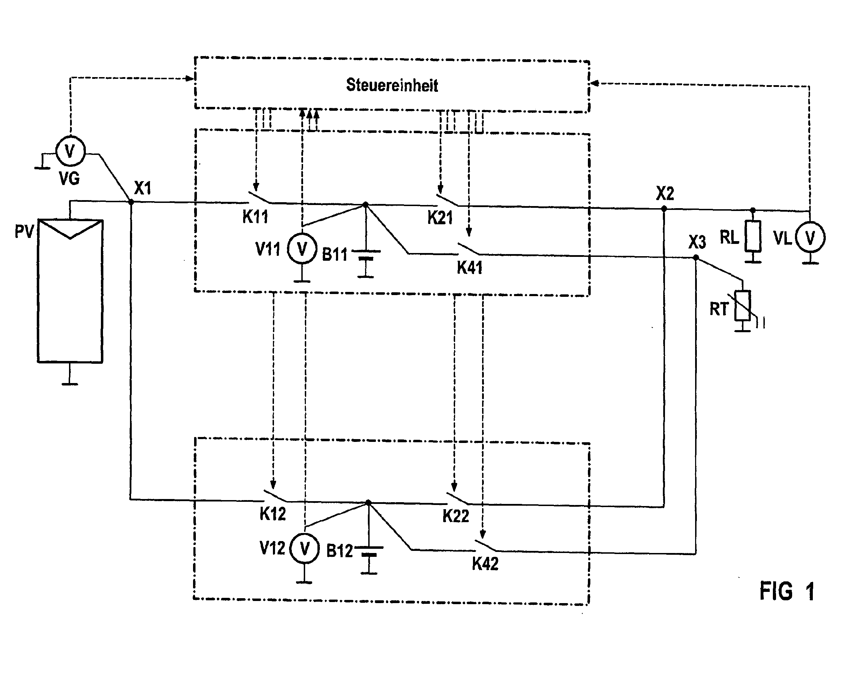

Fig. 1    ein Schaltbild einer Stromversorgungsanlage mit zwei Batteriezweigen,

Fig. 2    einen Funktionsplan zur Darstellung des erfindungsgemäßen Verfahrens,

Fig. 3    eine Messkurve zur Aufnahme einer aktuellen Entladekennlinie der Ruhespannung mittels stufenweiser Entladung,

Fig. 4    die ermittelte Ruhespannungskurve,

Fig. 5    die Ermittlung der Spannungsdifferenz auf der Ruhespannungskennlinie zwischen Messpunkten bei der Entladung einer Batterie an der Last und

Fig. 6    die Festlegung der Alarm-Ruhe-Spannung auf der Ruhespannungskennlinie.

Das Ausführungsbeispiel bezieht sich auf eine Stromversorgungsanlage mit zwei parallelen Batteriezweigen mit den Batterien B11 und B12, die langzeitig Lade- und Entladezyklen ausgesetzt sind und von einem photovoltaischen Generator PV nachgeladen werden, wobei parallel zu jeder Batterie B11, B12 jeweils ein Spannungsmesser V11, V12 sowie je ein Schalter K21, K22 mit in Reihe geschaltetem Testwiderstand RT angeordnet sind. Jeder Batteriezweig verfügt über je einen Generatorschalter K11, K12 und je einen Lastschalter K41, K42 zur Aufschaltung auf eine Last RL. Generatorseitig lässt sich die Spannung durch einen Spannungsmesser VG und an der Last RL durch einen Spannungsmesser VL bestimmen.

Nach dem Verfahren wird ein Test von aus dem Verbund der Stromversorgung herausgelösten einzelnen Batterien B11, B12 bzw. Batteriezweigen vorgenommen. Das Verfahren bezieht sich auf einen automatisierten Algorithmus zur Bestimmung von Parametern des augenblicklichen Zustandes der Batterien B11, B12 und der Ermittlung der Alterung und Restlebensdauer durch Vergleich mit in einem Messsystem gespeicherten Daten.

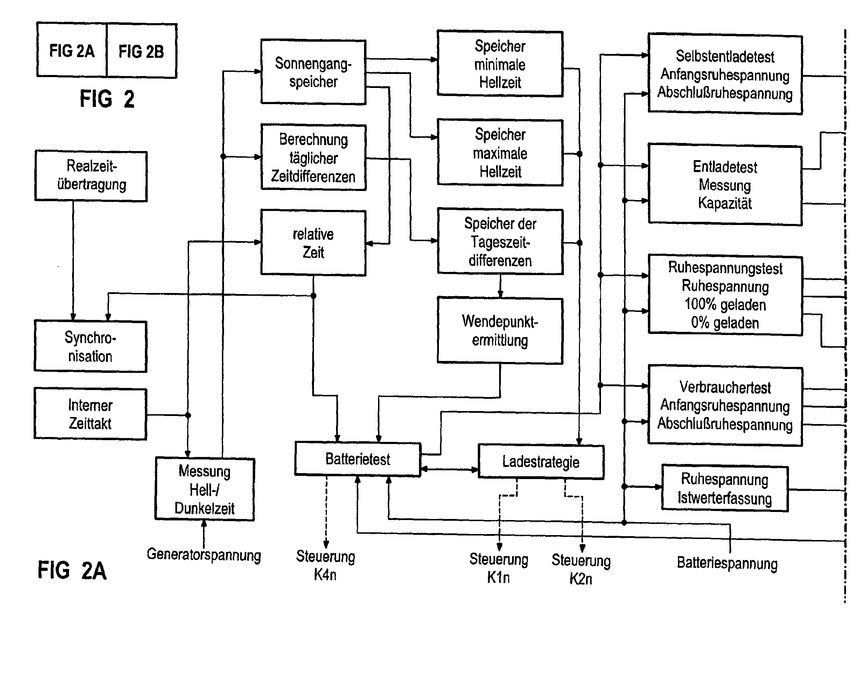

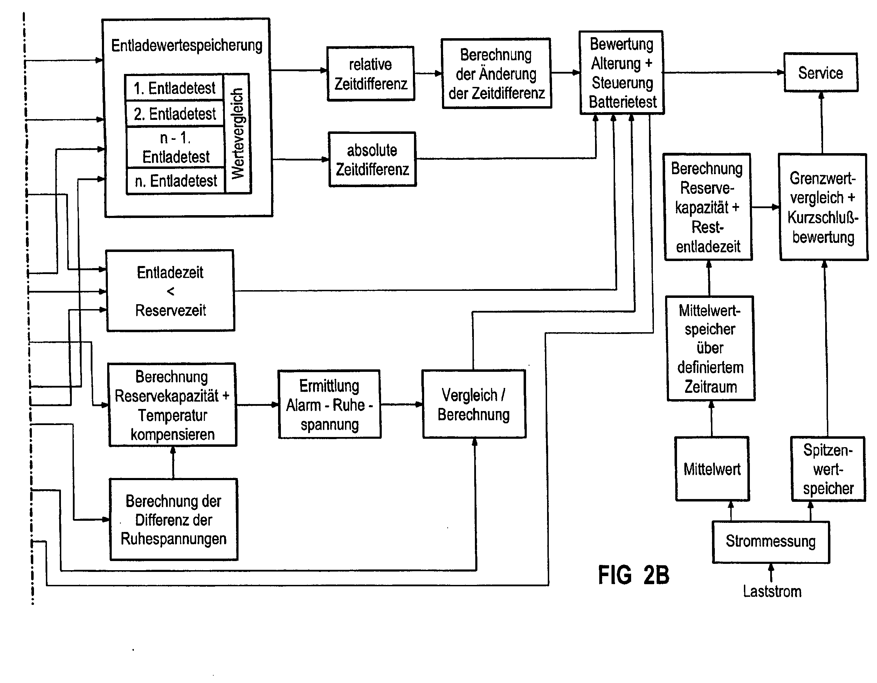

Unabhängig vom Betrieb der Stromversorgungen am Netz oder im Inselbetrieb besteht der Algorithmus aus zwei wesentlichen Teilkomplexen, die in Fig. 2 dargestellt sind.

Der erste Komplex bezieht sich auf die Berechnung des Verhaltens der Last zur Bestimmung einer durchschnittlichen Kapazität, die eine Batterie B11, B12 aufbringen muss, um deren Versorgung über einen vom Anwender festgelegten Restverfügbarkeitszeitraum aufrecht zu erhalten. Dazu wird der Laststrom einer vom Generator PV getrennten Batterie B11, B12 gemessen, der jeweilige Spitzenwert gespeichert und ein Mittelwert über einen Zeitraum (Tag, Woche, Monat) des Laststroms gebildet. Durch Festlegung der Zeit für die Restverfügbarkeit der Stromversorgung ergibt sich die notwendige Restkapazität der Batterie B11, B12.

Die Spitzenstrommessung dient der Unterscheidung zwischen Normalbetrieb und Überlast- bzw. Kurzschlussfall, während die ermittelte Restkapazität als Maß für die späteste Umschaltung auf einen anderen Batteriezweig oder zur Auslösung einer Alarmmeldung dient.

Der zweite Komplex bezieht sich auf die Messung einer Kennlinie über der Zeit einer aus dem Verbund der Stromversorgungsanlage herausgelösten Batterie B11, B12, die an einem Testwiderstand RT definiert bis zur Entladeschlussspannung U0% entladen wird. Anhand der Berechnung des Flächenintegrals zwischen Entladespannungsverlauf und Zeitachse wird das adäquate Maß der Restkapazität aus der Bestimmung des durchschnittlichen Laststromes zur Aufrechterhaltung der Stromversorgung ermittelt (erster Komplex). Das Zeitintervall in Höhe der Reservezeit wird vom Zeitpunkt des Erreichens der Entladeschlussspannung U0% zurückgerechnet.

Danach ergibt sich durch Interpolation zwischen Messwerten die Spannung, die als kritische Entladespannung bezeichnet wird, die als Maß der zur Verfügung stehenden Restenergie dient. Die Entladezeit wird als Absolutwert gespeichert und mit nachfolgenden Entladetests verglichen, wobei sowohl die Differenz zwischen den Entladezeiten als auch die Änderung der Differenz der Entladezeiten erfasst wird. Die Differenz der Zeiten zwischen zwei aufeinanderfolgenden Entladungen gilt als Maß der Alterung (Kapazitätsverlust), die im Vergleich zur ersten Entladezeit in relativen Bezug gesetzt werden kann. Der Vergleich der Differenzen der Entladezeiten erlaubt eine direkte Vorschau auf die Funktionsfähigkeit der Batterie B11, B12 bis zur nächsten Entladung.

Der Schritt der Unterscheidung zwischen einer Batterie am Ende des Lebenszyklus und einer Batterie, die aus welchen Gründen auch immer nicht vollständig geladen ist, wird dadurch gekennzeichnet, dass beim Zuschalten einer derartigen Batterie an die Last die Spannung so zusammenbricht, dass die Höhe der kritischen Entladespannung (Alarm-Ruhe-Spannung) erreicht ist. Wird eine derartige Batterie nachgeladen und am Testwiderstand RT teilentladen, kann anhand des Spannungsverhaltens der Batterie ein Schaden, bzw. das Ende des Lebenszyklus festgestellt werden, wenn die Spannung wiederum unter den Wert der kritischen Spannung zusammenbricht, andernfalls aber nur ein ungenügender Ladezustand vorliegt. Dazu wird der Vergleich mit der im Messsystem aus dem letzten Speichertest hinterlegten Entladekennlinie durchgeführt.

Da Parameter des Lastverhaltens mit betrachtet werden, kann die Lebensdauer des Energiespeichers selektiv für jede Stromversorgungsanlage bewertet werden. Somit kann die volle Dynamik der Änderung der Kapazität von Batterien im vom Anwender bestimmten Bereichen ausgenutzt und der Wartungsbedarf minimiert werden.

Bei Inselnetzanlagen mit photovoltaischem Generator wie im hier gezeigten Beispiel ergibt sich die Notwendigkeit der Definition von Zeitpunkten, zu denen ein Test von Batterien zulässig ist.

Das Verfahren besteht in derartigen Stromversorgungen darin, dass durch Messung der Hell-/Dunkelzeiten und Speicherung der tageszeitlichen Hellzeitdifferenzen der tatsächliche Sonnengang am jeweiligen Aufstellungsort der Anlage ermittelt wird und somit eine relative Zeitbasis unabhängig von kalendarischen Abweichungen für die internen Steuerungsabläufe gebildet wird. Weiterhin wird durch Bewertung der Differenzen der täglichen Sonnenläufe der Zeitraum ermittelt, der zur Durchführung von Batterietests sinnvoll ist.

Der nächste Schritt besteht darin, die jeweilig günstigste Ladestrategie für die Energiespeicher auf der Grundlage des ermittelten Sonnenganges festzulegen. Somit wird den unterschiedlichen Kriterien nach Aufrechterhaltung eines hochverfügbaren Anlagenzustandes Rechnung getragen. Die Ladestrategien beziehen sich auf drei grundsätzliche Varianten; einer ersten, die auf einer Umschaltung zwischen den Batteriezweigen in einem konstantem Zeitraster beruht, einer zweiten, bei der ein Batteriezweig die Last RL bis zum Erreichen der kritischen Entladespannung versorgt, während der Generator PV die anderen Batteriezweige nachlädt und einer dritten, bei der der Generator PV und ein Batteriezweig direkt mit der Last RL verbunden sind, während die anderen Batteriezweige im geladenen Zustand im Bereitschaftszustand stehen.

Ein weiterer Schritt besteht darin, eine Zeitsynchronisation zwischen der relativen Anlagenzeit und evtl. übertragenen Realzeitgrößen vorzunehmen, um sinnvolle Statusmeldungen über den Zustand der Anlage auszugeben, oder die Entscheidung über mögliche Batterietests zu verifizieren.

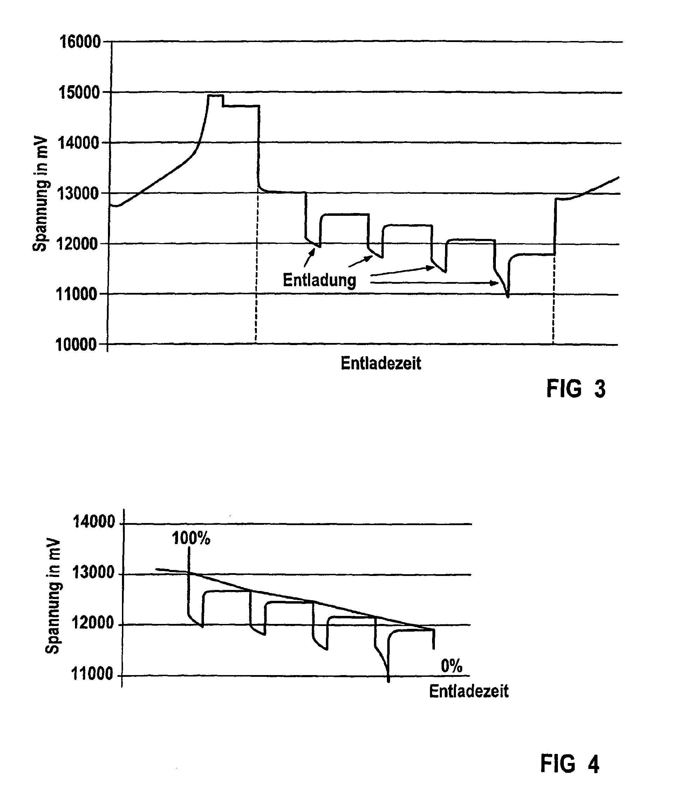

Fig. 3 zeigt den Verlauf der stufenweisen Entladung einer aus dem Verbund der Stromversorgungsanlage herausgelösten Batterie B11, B12. Deutlich zu erkennen sind die Entladespannung und das Ansteigen der Batteriespannung auf das Ruhespannungsniveau nach Abschalten des Testwiderstandes RT. Charakteristisch für das Entladeverhalten ist die Nichtlinearität der Entladekurve, wobei die Ruhespannungskennlinie mit guter Näherung einen annähernd linearen Charakter trägt. Diese Ruhespannungskennlinie entsteht durch die Punkte gleicher Ruhezeit nach Abschaltung der Entladung (Fig. 4).

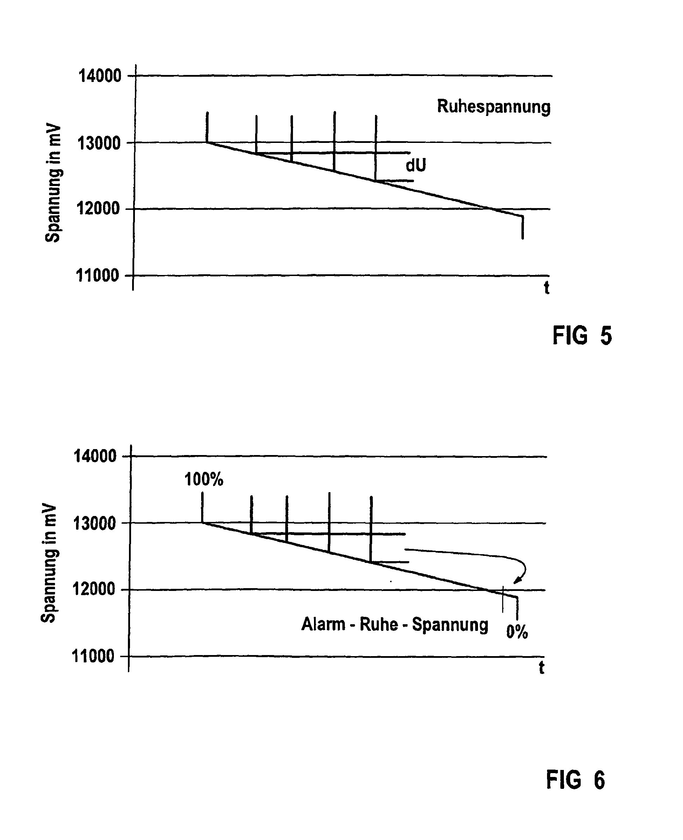

Zur Ermittlung der erforderlichen Restkapazität für die Versorgung der Last RL in der Reservezeit wird die Batterie B11 bzw. B12 vom Generator PV getrennt und nach Ablauf der Beruhigungszeit die Ruhespannung gemessen (Fig. 5). Danach erfolgt eine Umschaltung der Batteriezweige derart, dass die vom Generator PV getrennte und im Ruhezustand befindliche Batterie B11 bzw. B12 die Last RL versorgt. Nach festgelegten, vorzugsweise gleichen Zeitabschnitten wird diese Batterie B11 bzw. B12 von der Last RL getrennt, die Beruhigungszeit zur Erreichung der Ruhespannung abgewartet und die Differenz der Ruhespannung vom vorherigen Messpunkt ermittelt.

Durch Wiederholung dieser Messprozedur ergeben sich die Spannungsdifferenzen, die ein Maß der aus der Batterie B11, B12 zur Versorgung der Last RL erforderlichen Kapazität innerhalb einer bestimmten Zeit darstellen. Auf diese Art und Weise kann direkt das prozentuale Maß der notwendigen Restenergie zur Aufrechterhaltung der Stromversorgung bewertet werden, insbesondere dann, wenn die Spannungsdifferenz dU für einen Zeitraum in Höhe der Reservezeit gemessen wurde, wie Fig. 5 zeigt.

Mit Hilfe der Spannungsdifferenz dU kann die Alarm-Ruhe-Spannung berechnet werden, die das kritische Spannungsniveau der verfügbaren Restenergie kennzeichnet, wie Fig. 6 zeigt. Für den allgemeinen Fall gilt

$$\text{Alarm-Ruhe-Spannung} = U0\% + dU \times \frac{\text{Reservezeit}}{\text{Verbraucherlast-Test-Zeit}}$$

Diese kritische Entladespannung der Batterie B11, B12 muss für reale Einsatzbedingungen zumindest noch mit einer Temperaturkompensation korrigiert werden. Ein zusätzlicher Sicherheitsfaktor berücksichtigt den Kapazitätsverlust der Batterie B11, B12 bei tiefen Temperaturen. Dieser Faktor ist bei Temperaturen über Null °C immer 1. Unterhalb von Null °C wird dieser Faktor erhöht. Die Erhöhung erfolgt entsprechend Herstellerangaben oder durch die Auswertung von Versuchsmessungen.

$$\text{Alarm-Ruhe-Spannung} =$$

$$U0\% + dU \times \frac{\text{Reservezeit}}{\text{Verbraucher-Test-Zeit}} \times \text{Sicherheitsfaktor} + \text{Temperaturoffset}$$

$$\text{Temperaturoffset} = (U100\% - U0\%) \times (\text{Temperaturfaktor} - 1)$$

Der Temperaturfaktor ist in einer Tabelle im Messsystem abgelegt.
Der Sicherheitsfaktor kann in die Reservezeit integriert oder separat angegeben werden.

Durch diese Berechnungsmethode wird gezeigt, dass die Alarm-Ruhe-Spannung immer neu berechnet wird.

Nach dem beschriebenen Verfahren lässt sich eine sichere Restverfügbarkeit des Energiespeichers ermitteln und eine autonome Stromversorgung gezielt entsprechend dem jeweiligen Lastverhalten bis zum Ende des Lebenszyklus der Batterie betreiben.

**Patentansprüche**

1. Verfahren zur Bewertung des Zustandes von Batterien in batteriegestützten, photovoltaischen Stromversorgungsanlagen mit mindestens zwei parallelen Batteriezweigen, die je nach Ladezustand abwechselnd eine Last mit Energie versorgen oder von einem Generator nachgeladen werden, wobei

- von einer erstmalig an der Stromversorgungsanlage in Betrieb genommenen, aufgeladenen Batterie nach Freischaltung von der Stromversorgungsanlage mittels einer Steuereinheit selbsttätig in einem stufenweisen Entladezyklus an einem Entladewiderstand eine Entladekennlinie der Ruhespannung aufgenommen wird,
- dieser stufenweise Entladezyklus zu festzulegenden Zeitpunkten zur Aufnahme einer aktuellen Entladekennlinie der Ruhespannung wiederholt wird,
- mindestens die zuletzt aufgenommene aktuelle Entladekennlinie der Ruhespannung gespeichert wird und
- aus einer zuvor festgelegten Reservezeit und der bei der ersten Messung ermittelten Entladeschlussspannung aus der aktuellen Entladekennlinie der Ruhespannung eine Alarm-Ruhe-Spannung ermittelt wird, die ein Maß für eine jeweils noch verbleibende Restenergie der Batterie darstellt und bei deren Erreichen beim Betrieb an der Last eine Alarmierung des Betreibers der Stromversorgungsanlage erfolgt,

**dadurch gekennzeichnet, dass** aus der Verringerung der Entladezeit zwischen aufeinanderfolgenden Batterieentladungen der Zeitpunkt zur Aufnahme der nächsten aktuellen Entladekennlinie oder die Restverfügbarkeit der Batterie bestimmt wird.

2. Verfahren nach Anspruch 1,
**dadurch gekennzeichnet, dass** bei der Messung der aktuellen Entladekennlinie der Ruhespannung nur einzelne markante Punkte der Entladekennlinie angesteuert werden.

3. Verfahren nach einem der vorhergehenden Ansprüche,
**dadurch gekennzeichnet , dass** neben der Reservezeit nach dem gleichen Modus wie für die Reservezeit eine zusätzliche Vorwarnzeit ermittelt wird.

4. Verfahren nach einem der vorhergehenden Ansprüche,
**dadurch gekennzeichnet, dass** nach Überschreiten eines festgelegten Entladestromes im normalen Betrieb der Batterie eine aktuelle Entladekennlinie der Ruhespannung aufgenommen wird und die Batterie bei Abweichen von der zuletzt aufgenommenen, gespeicherten Entladekennlinie der Ruhespannung über festgelegte Werte hinaus außer Betrieb genommen wird.

5. Verfahren nach einem der vorhergehenden Ansprüche,
**dadurch gekennzeichnet, dass** der Mittelwert des Entladestromes an der Last ermittelt wird und daraus und aus der festgelegten Reservezeit für die Restverfügbarkeit der Stromversorgung eine Restkapazität der Batterie bestimmt wird, aus der anhand des Entladespannungsverlaufes bis zum Erreichen der Ladeschlussspannung die Alarm-Ruhe-Spannung korrigiert wird.

6. Verfahren nach einem der Ansprüche 1 bis 4,
**dadurch gekennzeichnet, dass** unter Verwendung der Last innerhalb eines vorbestimmbaren Zeitraumes der Verlauf der Ruhespannung gemessen und daraus und aus der festgelegten Reservezeit für die Restverfügbarkeit der Stromversorgung sowie der Entladeschlussspannung die Alarm-Ruhe-Spannung korrigiert wird.

7. Verfahren nach einem der vorhergehenden Ansprüche,
**dadurch gekennzeichnet, dass** zur ermittelten aktuellen Alarm-Ruhe-Spannung ein von der aktuellen Temperatur abhängiger Wert addiert wird.

8. Verfahren nach einem der vorhergehenden Ansprüche,
**dadurch gekennzeichnet, dass** im Inselbetrieb die Batterien in einem gewählten Zeitraster an die Last geschaltet werden und die jeweils zuletzt mit der Last verschaltete Batterie nachgeladen wird.

9. Verfahren nach einem der Ansprüche 1 bis 7, **dadurch gekennzeichnet, dass** im Inselbetrieb die an der Last befindliche Batterie jeweils bis zu ihrer Alarm-Ruhe-Spannung entladen und jeweils die am stärksten entladene Batterie nachgeladen wird.

10. Verfahren nach einem der Ansprüche 1 bis 7,
**dadurch gekennzeichnet, dass** im Inselbetrieb die Batterien zyklisch im Standby-Betrieb geladen werden.

11. Verfahren nach den Ansprüchen 8 bis 10,

**dadurch gekennzeichnet, dass** zyklisch zwischen den Lade-/Entladeverfahren umgeschalten wird.

12. Verfahren nach einem der vorhergehenden Ansprüche,
**dadurch gekennzeichnet, dass** die Aufnahme aktueller Entladekennlinien der Ruhespannung bei Nachladung mittels der photovoltaischen Stromversorgungsanlagen nur in einem festzulegenden Zeitfenster im Bereich genügend hoher Sonneneinstrahlung erfolgt.

13. Verfahren nach Anspruch 12,
**dadurch gekennzeichnet, dass** die Zeitbasis für das Zeitfenster sowie andere Betriebs- und Testabläufe als relative, von der Realzeit unabhängige Zeitbasis durch Messung der täglichen Hell-/Dunkelzeiten sowie deren Änderung von der Stromversorgungsanlage selbst ermittelt wird.

**Claims**

1. Method for assessment of the state of batteries in battery-supported, photovoltaic power supply systems having at least two parallel battery paths, which alternately supply a load with power or are recharged from a generator depending on the state of charge,
in which

   - after disconnection from the power supply system, a discharge characteristic of the no-load voltage is recorded automatically by means of a control unit across a discharge resistance during a stage-by-stage discharge cycle from a charged battery which is being operated for the first time on the power supply system,
   - this stage-by-stage discharge cycle is repeated at times which can be defined, in order to record an instantaneous discharge characteristic of the no-load voltage,
   - at least the most recently recorded instantaneous discharge characteristic of the no-load voltage is stored, and
   - an alarm no-load voltage is determined from the instantaneous discharge characteristic of the no-load voltage from a previously defined reserve time and from the final discharge voltage as determined in the first measurement, which alarm no-load voltage represents a measure of the energy which in each case still remains in the battery, and on reaching which during operation on the load, an alarm is produced for the operator of the power supply system

   **characterized in that**
   the time for recording the next instantaneous discharge characteristic, or the remaining availability of the battery, is determined from the reduction in the discharge time between successive battery discharges.

2. Method according to Claim 1,
**characterized in that**
only individual significant points on the discharge characteristic are driven to during the measurement of the instantaneous discharge characteristic of the no-load voltage.

3. Method according to one of the preceding claims,
**characterized in that**,
in addition to the reserve time, an additional prewarning time is determined using the same mode as for the reserve time.

4. Method according to one of the preceding claims,
**characterized in that**,
once a defined discharge current has been exceeded during normal operation of the battery, an instantaneous discharge characteristic for the no-load voltage is recorded, and the battery is taken out of use if there is any discrepancy from the most recently recorded, stored discharge characteristic of the no-load voltage beyond defined values.

5. Method according to one of the preceding claims,
**characterized in that**
the mean value of the discharge current is determined at the load, and a remaining capacity of the battery is determined from this and from the defined reserve time for the remaining availability of the power supply, from which the alarm no-load voltage is corrected on the basis of the discharge voltage profile until the final charge voltage is reached.

6. Method according to one of Claims 1 to 4,
   **characterized in that**
   the profile of the no-load voltage is measured using the load within a time period which can be determined, and the alarm no-load voltage is corrected from this and from the defined reserve time for the remaining availability of the power supply, and from the final charge voltage.

7. Method according to one of the preceding claims,
   **characterized in that**
   a value which is dependent on the instantaneous temperature is added to the determined instantaneous alarm no-load voltage.

8. Method according to one of the preceding claims,
   **characterized in that**
   in the island mode, the batteries are connected to the load in a chosen time pattern, and the battery which was in each case connected to the load most recently is recharged.

9. The method according to one of claims 1 to 7,
   **characterized in that**
   in the island mode, the battery which is connected to the load is in each case discharged down to its alarm no-load voltage, and the battery which is most heavily discharged is in each case recharged.

10. Method according to one of Claims 1 to 7,
    **characterized in that**
    in the island mode, the batteries are charged cyclically in the standby mode.

11. Method according to Claims 8 to 10,
    **characterized in that**
    cyclic switching takes place between the charging/discharge method.

12. Method according to one of the preceding claims,
    **characterized in that**
    instantaneous discharge characteristics of the no-load voltage during recharging by means of photovoltaic power supply systems are recorded only in a time window, which can be defined, in the area of sufficiently high solar radiation.

13. Method according to Claim 12,
    **characterized in that**
    the time basis for the time window as well as other operating and test procedures is determined as a relative time basis, which is independent of the actual time, by measurement of the daily daytime/nighttime hours and also the change therein from the power supply system itself.

**Revendications**

1. Procédé d'évaluation de l'état de batteries dans des installations photovoltaïques d'alimentation en courant assistées par batterie, comprenant au moins deux branches parallèles de batterie qui, suivant l'état de charge, alimentent en alternance une charge en énergie ou sont rechargées par un générateur, dans lequel

   - d'une batterie chargée entrée en service pour la première fois sur l'installation d'alimentation en courant, on enregistre, après déconnexion de l'installation de l'alimentation en courant, au moyen d'une unité de commande automatiquement, dans un cycle de décharge pas à pas sur une résistance de décharge, une courbe caractéristique de décharge de la tension de repos,
   - on répète ce cycle de décharge pas à pas à des instants fixés pour enregistrer une courbe caractéristique de décharge instantanée de la tension de repos.
   - on mémorise au moins la courbe caractéristique de décharge instantanée enregistrée en dernier de la tension de repos et
   - à partir d'un temps de réserve fixé à l'avance et de la tension finale de décharge déterminée lors de la première mesure, on détermine, à partir de la courbe caractéristique de décharge instantanée de la tension de repos, une tension de repos d'alerte, qui représente une mesure de l'énergie résiduelle de la batterie restant encore et on produit, lorsqu'elle est atteinte lors du fonctionnement sur la charge, une alerte de l'opérateur de l'installation de l'alimentation en courant,

- **caractérisé en ce que** l'on détermine, à partir de la diminution du temps de décharge entre des décharges successives de la batterie, l'instant d'enregistrement de la courbe caractéristique de décharge instantanée suivante ou la disponibilité résiduelle de la batterie.

**2.** Procédé suivant la revendication 1, **caractérisé en ce que** lors de la mesure de la courbe caractéristique de décharge instantanée de la tension de repos, on ne règle que des points individuels marquants de la courbe caractéristique de décharge.

**3.** Procédé suivant l'une des revendications précédentes, **caractérisé en ce que** l'on détermine outre le temps de réserve, par le même mode que pour le temps de réserve un temps d'avertissement supplémentaire.

**4.** Procédé suivant l'une des revendications précédentes, **caractérisé en ce que**, après dépassement d'un courant de décharge fixé en fonctionnement normal de la batterie, on enregistre une courbe de décharge instantanée de la tension de repos et on met la batterie hors service si l'on s'écarte au-delà de valeurs fixées de la courbe caractéristique de décharge mémorisée et enregistrée en dernier de la tension de repos.

**5.** Procédé suivant l'une des revendications précédentes, **caractérisé en ce que** l'on détermine la valeur moyenne du courant de décharge sur la charge et on en détermine et à partir du temps de réserve fixé pour la disponibilité résiduelle de l'alimentation en courant une capacité résiduelle de la batterie, à partir de laquelle on corrige la tension de repos d'alerte au moyen de la courbe de tension de décharge jusqu'à ce que l'on atteigne la tension finale de charge.

**6.** Procédé suivant l'une des revendications 1 à 4, **caractérisé en ce qu'**en utilisant la charge, on mesure, dans un laps de temps pouvant être déterminé à l'avance, la courbe de la tension de repos et à partir d'elle et du temps de réserve fixé pour la disponibilité résiduelle de l'alimentation en courant ainsi que de la tension finale de décharge, on corrige la tension de repos d'alerte.

**7.** Procédé suivant l'une des revendications précédentes, **caractérisé en ce que**, pour la tension de repos d'alerte instantanée déterminée, on additionne une valeur qui dépend de la température instantanée.

**8.** Procédé suivant l'une des revendications précédentes, **caractérisé en ce qu'**en fonctionnement autonome on branche les batteries sur la charge dans une trame de temps choisie et on recharge la batterie branchée respectivement en dernier sur la charge.

**9.** Procédé suivant l'une des revendications 1 à 7, **caractérisé en ce qu'**en fonctionnement autonome, on décharge la batterie se trouvant sur la charge jusqu'à sa tension de repos d'alerte et on recharge la batterie la plus déchargée.

**10.** Procédé suivant l'une des revendications 1 à 7, **caractérisé en ce qu'**en fonctionnement autonome, on charge des batteries cycliquement en fonctionnement de secours.

**11.** Procédé suivant les revendications 8 à 10,
**caractérisé en ce qu'**on inverse cycliquement entre les procédés de charge et les procédés de décharge.

**12.** Procédé suivant l'une des revendications précédentes, **caractérisé en ce qu'**on effectue l'enregistrement de courbes caractéristiques de décharge instantanées de la tension de repos lors de la recharge au moyen des installations photovoltaïques d'alimentation en courant, seulement dans un créneau temporel fixé lorsque le rayonnement solaire est suffisamment intense.

**13.** Procédé suivant la revendication 12, **caractérisé en ce que** l'on détermine automatiquement la base de temps pour le créneau temporel ainsi que d'autres courbes de fonctionnement et de test sous la forme d'une base de temps relative, indépendante du temps réel, en mesurant les durées quotidiennes de clarté/obscurité ainsi que leur modification par l'installation d'alimentation en courant.

FIG 1

FIG 2

| FIG 2A | FIG 2B |

Selbstentladetest
Anfangsruhespannung
Abschlußruhespannung

Entladetest
Messung
Kapazität

Ruhespannungstest
Ruhespannung
100% geladen
0% geladen

Verbrauchertest
Anfangsruhespannung
Abschlußruhespannung

Ruhespannung
Istwerterfassung

Batteriespannung

Speicher
minimale
Hellzeit

Speicher
maximale
Hellzeit

Speicher der
Tageszeitdifferenzen

Wendepunktermittlung

Ladestrategie

Steuerung K2n

Steuerung K1n

Sonnengangspeicher

Berechnung
täglicher
Zeitdifferenzen

relative
Zeit

Batterietest

Steuerung K4n

Messung
Hell-/
Dunkelzeit

Generatorspannung

Realzeitübertragung

Synchronisation

Interner
Zeittakt

FIG 2A

14

EP 1 326 084 B1

FIG 2B

FIG 3

FIG 4

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4731601 A
- DE 19605481 C1
- DE 4238316 A1
- DE 3821808 A1
- DE 3910868 A1